# EUROPEAN PATENT APPLICATION

(11) **EP 1 637 274 A1**
(43) Date of publication of application: **22.03.2006**
(21) Application number: 05255395.5
(22) Date of filing: 02.09.2005
(51) Int. Cl.: B23K 26/34

(54) **Forming structures by laser deposition**

(30) Priority: 16.09.2004 GB 0420578
(71) Applicant: ROLLS-ROYCE PLC, London, SW1E 6AT (GB); SKY+ Limited, Napa, CA 94581-0299 (US)
(72) Inventor: Withey, Paul Anthony, Chellaston, Derby, DE73 1PN (GB); Schlienger, Max Eric, Napa,California, 94581-0299 (US)
(74) Representative: Parnham, Kevin

(57) **Abstract**

A method of forming at least a part of a single crystal component (34) comprising a base material, the method comprises the steps of; directing a flow of base material (24) at a first location (22) on a substrate (26, 34), directing a laser (20) towards the first location (22) to fuse the flow of base material (24) with the substrate (26, 34) thereby forming a deposit (22) on the substrate (26), characterised in that, the method comprises controlling the rate of cooling of the deposit (22) and/or substrate (26, 34) so that the single crystal extends into the deposit (22).

## Description

The present invention relates to a method for forming structures using direct laser deposition and in particular a method and apparatus of controlling the crystal orientation within the structure.

Direct laser deposition is a known process capable of forming complex structures and is disclosed in US6,391,251. Briefly, a laser is used to heat a substrate to form a pool of molten material and then a jet of powder is directed into the pool. The base material absorbs the heat from the molten pool and the powder solidifies forming the structure. By controlling the amount of powder and the location of the laser on the substrate, complex structures may be formed. This process allows a near net material direct manufacture of structures.

For gas turbine engine blades and the like, one advantage of this process over the current casting process is that complex aerofoil shapes can be manufactured directly from the computer aided design model without the need for the core, wax and shell elements in the traditional casting process.

However, certain structures such as turbine blades and seals are manufactured comprising a single crystal. Such single crystal components provide improved heat resistance, strength and durability over their multi-directional, multi-crystal equivalents. Furthermore, the direction of the crystal is important to the performance characteristics of the single crystal structured component.

The process disclosed in US6,391,251 is only capable of forming multi-directional, multi-crystal structures as the substrate and/or formed structure used is of multi-crystal origin and there is no provision for controlling the rate and direction of cooling necessary for the formation of directional, single crystal components.

Therefore it is an object of the present invention to provide a method of manufacturing single-direction, single-crystal components using direct laser deposition.

In accordance with the present invention a method of forming at least a part of a single crystal component comprising a base material, the method comprises the steps of; directing a flow of base material at a first location on a substrate, directing a laser towards the first location to fuse the flow of base material with the substrate thereby forming a deposit on the substrate, characterised in that, the method comprises controlling the rate of cooling of the deposit and/or substrate so that the single crystal extends into the deposit.

Preferably, the step of controlling rate of cooling controls the thermal gradient between the deposit and the substrate/component controls the direction of the crystal orientation.

In addition to providing heat to melt the deposit the method comprises the step of applying heat to the substrate or component at least in the location of the deposit to ensure a fully molten pool is present prior to cooling. It is preferred to use second laser directed at the substrate to provide additional heating.

Importantly, the method comprises the preferred step of cleaning the substrate prior to deposition to remove at least an oxide layer and for the same reason to prevent stray crystal grains from forming, the method is carried out in a substantially oxygen free environment. Typically, a means to shroud the deposit location in an inert gas is provided.

It is intended for the method to be predominantly used for manufacturing a component comprising an alloy and preferably a superalloy.

The component is intended, although not exclusively, for use in a gas turbine engine component and is preferably a turbine blade, but could also be a turbine vane or a seal segment.

A variation of the method described above, comprising the step of adjusting the power of the laser(s) to control the temperature of the molten deposit and thus the rate of cooling of the deposit as the thermal gradient is altered.

Preferably, the method comprises the step of monitoring the temperature of the deposit and/or substrate/component via thermal detection equipment. In response to the monitored temperature the method comprises the step of adjusting the rate of cooling of the deposit and/or substrate.

The method as described in the above paragraphs is intended, but not exclusively, for use wherein a programmable computer is provided to automate at least one step of the method.

Preferably, the method comprises the step of programming the computer with a computer aided design model of the shape of the component, the computer capable of controlling the location of the deposit.

A further step of programming the computer is to control the rate of flow of the base material.

Importantly, the method preferably comprises the step of programming the computer to control the power of the laser depending on any one of the group comprising the temperature of the deposit, the flow rate of the base material or the rate of forming the component.

To reliably manufacture components comprising the single crystal the method comprises the step of programming the computer to control the rate of cooling of the deposit and/or substrate/component so the single crystal extends into the deposit. It is preferred that the rate of cooling of the deposit and/or substrate/component is controlled by computer controlled adjustment to any one of the group comprising the flow of cooling fluid, the power of the laser(s) or the rate of forming the component. By monitoring the temperature of the deposit and/or substrate/component via thermal detection equipment, inputting the temperature into the computer and in response to a predetermined set of rules outputting a response to control the adjustment to ensure a preferential thermal gradient exists for single crystal growth into the deposit.

The method described above may advantageously be applied to repairing a component.

According to another aspect of the present invention, apparatus is provided for forming at least a part of a single crystal component comprising a base material comprising; apparatus capable of directing a flow of base material at a first location on a substrate, a laser capable of directing a laser beam towards the first location to fuse the flow of base material with the substrate thereby forming a deposit on the substrate, characterised in that, the apparatus includes means for controlling the rate of cooling of the deposit and/or substrate so that the single crystal extends into the deposit.

Preferably, the means for controlling the rate of cooling comprises a jet of fluid and the cooling fluid comprises a flow of inert gas.

Preferably, the apparatus according to the preceding two paragraphs comprises a programmable computer capable of controlling any one of the location of the deposit, the power of the laser or the rate of cooling of the deposit and/or substrate/component.

The present invention will be more fully described by way of example with reference to the accompanying drawings in which:
Figure 1 shows apparatus of a prior art method,
Figure 2 shows apparatus of the method of the present invention,
Figure 3 is a schematic illustration of an inert gas shroud,
Figure 4 is a schematic illustration of the apparatus of the present invention within an evacuated chamber and/or a furnace.

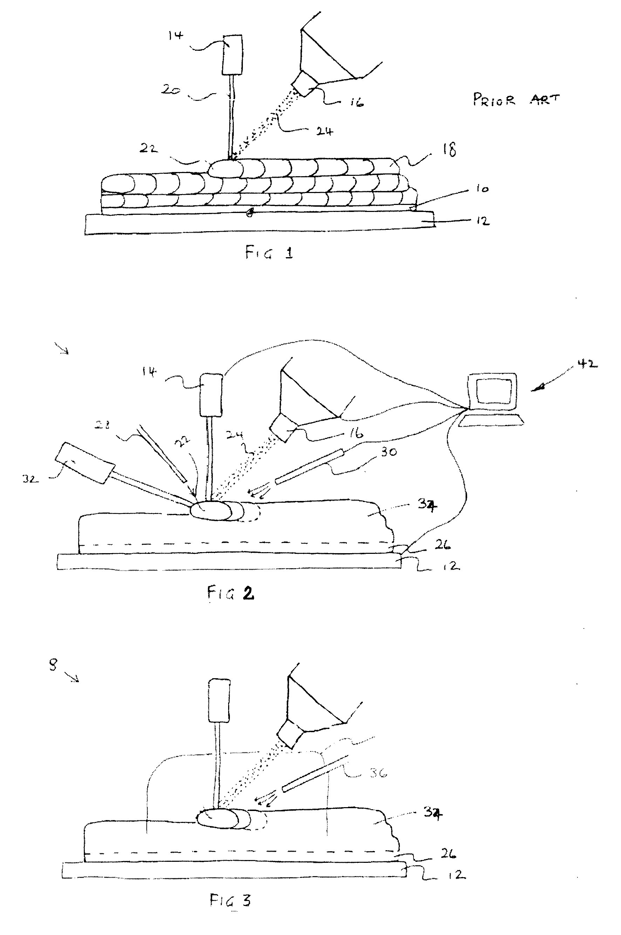

Referring to Figure 1, the prior art apparatus comprises a substrate 10 mounted to a table 12, moveable relative to a laser 14 and a powder delivery nozzle 16. The method of forming a structure 18 comprises directing a laser beam 20 from the laser 14 onto the substrate 10 or later the forming structure 18, to create a pool of molten metal 22 into which a metal powder 24 jet is then directed. Once sufficient powder has been deposited a relatively thin layer of metal remains. The substrate 10 and forming structure 18 are translated so that the structure is formed in layer-wise manner. This process allows a near net material direct manufacture of structures.

By controlling the amount of powder and the location of the base material simple and complex structures may be formed. For gas turbine engine blades and the like, one advantage of this process over the current casting process is that complex aerofoil shapes can be manufactured directly from a computer aided design model without the need for traditional core, wax and shell process steps. It is an essential part of this process that the laser, delivery of the powder jet and location of the deposit are computer controlled. Such a computer controlled process is described in US6,391,251.

However, one drawback of this prior art method is that there is no provision of a means for thermal management during the process and in particular no means for controlling the rate of cooling the deposit and surrounding substrate. Consequently the structure formed comprises multi-directional, multi-crystalline structures.

Referring now to Figure 2 where like features have the same reference numbers as Figure 1. The apparatus of the present invention comprises a means for controlling the rate of cooling 28 to ensure the successful growth and direction of single crystal components 34. For the present invention a substrate 26 (or component 34 if repair is being effected) is directionally solidified or comprises a single crystal. Thus as the molten powder pool 22 cools and solidifies, the grain structure of the substrate grows through and into the deposit 22.

Thus the method of the present invention for forming a single crystal component 18 comprises directing a flow of base material 24 at a first location 22 on a substrate 26, directing a laser beam 20 towards the first location 22 to fuse the flow of base material with the substrate thereby forming a deposit 22 on the substrate 26 or the component 18 as it is built up. The present invention is particularly concerned with the continuation of the single crystal of the substrate 26 or component 34 into the deposit 22; this is achieved by controlling the rate of cooling of the deposit 22 and/or substrate 26.

The present invention requires the use of a substrate 26 or component 34 comprising a metal or metallic alloy or superalloy capable of forming a single crystal structure. Such metals, alloys and superalloys are well known in the industry, however, three preferred alloys comprise the following elements; their quantities are given as % by weight and the balance of the material is Ni plus incidental impurities;

**Table 1**

| Name | Ni | Cr | Co | Mo | Al | Ti | W | Ta | V | Hf | Mn | Zr | Si | Re | Fe |
|---|---|---|---|---|---|---|---|---|---|---|---|---|---|---|---|
| SRR99 | Bal | 8.5 | 5 | | 5.5 | 2.2 | 9.5 | 2.8 | 0.1 | | 0.1 | 0.01 | 0.1 | | 0.1 |
| CMSX-4 | Bal | 6.4 | 9.6 | 0.6 | 5.6 | 1 | 6.4 | 6.5 | | 0.1 | | | | 3 | |
| CMSX-10 | Bal | 2.2 | 3.3 | 0.4 | 5.8 | 0.2 | 5.5 | 8.3 | | | | | | 6.2 | |

With reference to Table 1, SRR99 is a proprietary product of Rolls-Royce plc, of Derby, UK; CMSX-4 and CMSX-10 are trade names and are available from Cannon Muskegon, Box 506, Muskegon, MI, 49443, USA. Other such alloys are readily substitutable and the table above is not intended to be limiting, merely illustrative.

To grow the single crystal of the substrate 26 into the deposit 22, for these and other alloys and superalloys, a preferred rate of cooling of the molten deposit is controlled to give a crystal growth rate of less than 10⁻³ ms⁻¹. Where suitable apparatus and temperature measurement capabilities are present a rate of cooling is controlled to give a crystal growth rate of less than 10⁻⁴ ms⁻¹ is preferred. For particularly high temperature and highly stressed components it is preferable to control the crystal growth rate to less than 10⁻⁵ ms⁻¹. Generally, the lower the growth rate the lower the scrap rate although this is balanced by the rate of manufacture of the components.

Enhancement of the process is achieved where the rate of deposition and/or the flow rate of base material is controlled to between 0.01kg per hour and 1 kg per hour. However, it should be appreciated that matching of the rate of cooling and the rate of deposition are interrelated. Preferably, the rate of deposition or flow of base material is controlled to between 0.075kg per hour and 0.3kg per hour for a rate of crystal growth less than 10⁻⁴ ms-¹. An exemplary embodiment of the present invention for a high temperature and highly stressed component comprises a rate of deposition or (flow of base material) of 0.15kg per hour and a cooling rate which provides a crystal growth rate of 5 x 10⁻⁵ ms-1.

It should be appreciated that the rate of deposition is effected via control of the means 12 for relative movement between the substrate and the deposition location and/or in combination with the flow rate of the base material.

In a further step, control of the rate of cooling of the deposit is achieved by adjusting the power of the laser 14 to control the temperature of the molten deposit 22. Thus the greater the amount of energy and heat imparted by the laser 14, the greater the temperature gradient is. Thus the power of the laser 14 and also the second laser 32 may be adjusted depending on the temperature desired for single crystal growth and in response to installed thermal detection equipment 44.

To reduce scrap rate and improve quality, the process further comprises cooling the substrate/component below the deposit 22 temperature to ensure a suitable thermal gradient, typically 3000Km⁻¹, exists between the substrate/component and which also facilitate the desired direction of crystal grain growth. The apparatus 8 therefore comprises a second cooling fluid flow means 30 directed substantially at the substrate/component 26, 18 near to the recently formed deposit 22.

Although the method preferably uses a flow of base material 24 in the form of a spray of powder, it is possible to use of a liquid jet of molten material or flow in the form of liquid droplets. As mentioned hereinbefore, it is essential that the molten pool 22 does not comprise solid material, which might create a multi-crystal structure, and therefore a second laser 32 provided to impart heat into the substrate 34 around the location of the deposit. Where a second laser 32 is used the first laser 14 is directed at the powder, liquid or liquid droplet jet 24 to ensure the jet is fully molten at impact with the deposit location 22.

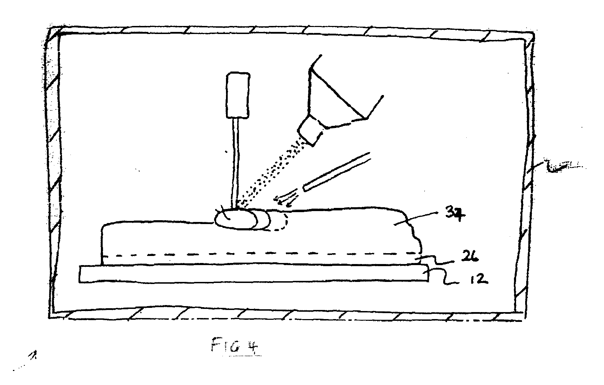

Rather than using a second laser 32 to heat the substrate or component the apparatus 8 is placed in a furnace 40 (figure 4). Alternatively, the component 34 is locally heated using a directional energy source such as an electron beam (shown by 32 figure 2) or a current passing through the surface of the substrate 26 or component 34. It is important that none of the powder material remains solid, as this is likely to give rise to the formation of non-orientation compliant crystal grains. Whatever the means for a second heat source 32 it is desired to heat the area of the component 34 just below the deposition layer 22 to allow a consistent growth of the crystal. The layer is required to be fully molten to allow only the single crystal to grow into it; solid particles or masses can cause undesirable secondary grains to grow.

Where single crystal growth is desired it is known to include the method step of cleaning the substrate or component of any surface impurities or particles prior to the deposition process. In particular the cleaning process involves removal of at least an oxide layer.

As single crystal growth is paramount to the present invention, it is highly desirable that the process is completed in a substantially oxygen free environment. Due to the high temperatures involved during the process, oxidation of the deposit or component readily occurs and causes an impurity capable of starting a crystal grain to grow. This substantially oxygen free environment is achieved by providing a means to provided to shroud of inert gas around at least the deposition location 22. Figure 3 shows a means to shroud 36, 38 the deposition location comprising a shield 38 substantially surrounding the deposition location and a supply of inert gas 36. It is also possible for the means to shroud the deposition location 22 to do without the shield and instead or as well as, to have a supply of inert gas generally coaxially to the laser beam 20.

The means for supplying an inert gas 36 may also be adapted as the means for supplying a cooling fluid 30 to control the cooling of the deposit and surrounding component.

As an alternative to the means to shroud 36, 38, the apparatus for forming at least a part of a single crystal component 34 is placed in an evacuated or substantially evacuated chamber 40, thereby preventing at least oxidation of the component.

The method for forming at least a part of a single crystal component is suitable for gas turbine engine components such as a blade or a vane and particularly a turbine blade, a turbine vane or a seal segment.

It should be appreciated that the process or a step of the process is capable of being automated via computer 42 control (Figure 2). In the preferred process of the present invention, the computer 42 is programmed for the preferred rate of deposition via relative movement between the component 34, mounted on the table 12, and the deposition location 22 or the same relative movement in combination with the flow rate of the base material. The computer 42 is also programmable to control the power of the first and second lasers 14, 32 dependent on the base material used, the rate of deposition and environment selected. The computer 42 is further programmable to monitor and respond to the temperature of the molten pool 22 and surrounding component 34, via thermal detection equipment 44, to ensure a preferential thermal gradient exists for single crystal growth into the deposit 22.

In a preferred embodiment of the present invention, the method comprises the step of programming the computer 42 with a computer aided design model of the shape of the component 34 and the computer controlling the location of the deposit 22.

Furthermore, the method is enhanced with the step of programming the computer 42 to control the power of the laser 14 in response to achieving a desired temperature of the deposit 22 or a change in the flow rate of the base material or the rate of forming the component 34.

Still further, the method comprises the step of programming the computer 42 to control the rate of cooling of the deposit 22 and/or substrate/component 26, 34 via response to pre-selected parameters to any one of the group comprising the flow of cooling fluid, the power of the laser(s) 14 or the rate of forming the component 34. In particular, the temperature of the deposit 22 and/or substrate/component 26, 34 is monitored via thermal detection equipment 44. The temperature is inputted to the computer 42 and in response to a predetermined set of rules the computer outputs a response to control the adjustment to ensure a preferential thermal gradient exists for single crystal growth into the deposit 22.

An important aspect of the present invention is the use of the method for repairing a single crystal component 34 that has suffered some form of manufacturing defect or in-service damage or wear.

## Claims

1. A method of forming at least a part of a single crystal component (34) comprising a base material, the method comprises the steps of;
directing a flow of base material (24) at a first location (22) on a substrate (26, 34),
directing a laser (20) towards the first location (22) to fuse the flow of base material (24) with the substrate (26, 34) thereby forming a deposit (22) on the substrate (26),
**characterised in that**, the method comprises controlling the rate of cooling of the deposit (22) and/or substrate (26, 34) so that the single crystal extends into the deposit (22).

2. A method according to claim 1, wherein the rate of cooling is controlled to give a crystal growth rate of less than 10⁻³ ms⁻¹.

3. A method according to claim 1, wherein the rate of cooling is controlled to deliver a crystal growth rate less than 10⁻⁴ ms⁻¹.

4. A method according to claim 1, wherein the rate of cooling is controlled to provide a crystal growth rate of 5 x 10⁻⁵ ms⁻¹.

5. A method according to any one of claims 1-4, wherein the rate of deposition is controlled to between 0.01kg per hour and 1kg per hour.

6. A method according to any one of claims 1-4, wherein the rate of deposition is controlled to between 0.075kg per hour and 0.3kg per hour.

7. A method according to any one of claims 1-4, wherein the rate of deposition is controlled to 0.15kg per hour.

8. A method according to any one of claims 1-7, wherein the step of controlling rate of cooling controls the thermal gradient between the deposit and the substrate/component controls the direction of the crystal orientation.

9. A method according to any one of claims 1-8, wherein the flow of base material (24) is in the form of a spray of powder.

10. A method according to any one of claims 1-8, wherein the flow of base material (24) is in the form of a liquid jet of molten material.

11. A method according to any one of claims 1-8, wherein the flow of base material (24) is in the form of liquid droplets.

12. A method according to any one of claims 1-11, wherein a layer of deposit (22) is formed on the substrate (26, 34) via operation of a means (12) for relative movement between the substrate (26, 34) and the deposit (22).

13. A method according to any one of claims 1-12, wherein the substrate (26, 34) is part of the single crystal component (34).

14. A method according to any one of claims 1-12 comprising the step of applying heat to the substrate (26) or component (34) at least in the location of the deposit (22).

15. A method according to claim 14, wherein the heat is applied to the substrate (26, 34) at least in the location of the deposit (22) via a second laser (32) directed at the substrate (26, 34).

16. A method according to claim 14, wherein the heat is applied to the substrate (26, 34) at least in the location of the deposit (22) via an electron beam (32) directed at the substrate (26, 34).

17. A method according to claim 14, wherein heat is applied to the substrate (26, 34) at least in the location of the deposit (22) via a means to supply an electric current through the substrate (26, 34).

18. A method according to claim 14, wherein heat is applied to the substrate (26, 34) at least in the location of the deposit (22) via placement of the apparatus of claims 1-10 in a furnace (40).

19. A method according to any one of claims 1-18 comprising the step of cleaning the substrate (26, 34) prior to deposition to remove at least an oxide layer.

20. A method according to any one of claims 1-19, wherein the method is carried out in a substantially oxygen free environment.

21. A method according to any one of claims 1-20 wherein a means (36, 38) is provided to shroud the deposit location in an inert gas.

22. A method according to any one of claims 1-20, wherein the method is carried out in an environment (40) substantially evacuated.

23. A method as claimed in any one of claims 1-22, wherein the component (34) comprises a metal.

24. A method as claimed in claim 23, wherein the component (34) comprises an alloy or a superalloy.

25. A method as claimed in any one of claims 1-18, wherein the component (34) comprises any one of the group comprising SRR99, CMSX-4 and CMSX-10.

26. A method as claimed in any one of claims 1-25, wherein the component (34) is a gas turbine engine component such as a turbine blade, a turbine vane or a seal segment.

27. A method as claimed in any one of claims 1-26 comprising the step of adjusting the power of the laser (14) to control the temperature of the molten deposit (22) and thus the rate of cooling of the deposit (22).

28. A method as claimed in any one of claims 1-27 comprising the step of monitoring the temperature of the deposit (22) and/or substrate/component (26, 34) via thermal detection equipment (44).

29. A method as claimed in claim 28 comprising the step of adjusting the rate of cooling of the deposit (22) and/or substrate (26) in response to the monitored temperature.

30. A method as claimed in any one of claims 1-28 wherein a programmable computer (42) is provided to automate at least one step of the claimed method.

31. A method as claimed in claim 30 comprising the step of programming the computer (42) with a computer aided design model of the shape of the component (34), the computer capable of controlling the location of the deposit (22).

32. A method as claimed in any one of claims 30-31 comprising the step of programming the computer (42) to control the rate of flow of the base material.

33. A method as claimed in any one of claims 30-32 comprising the step of programming the computer (42) to control the power of the laser (14) depending on any one of the group comprising the temperature of the deposit (22), the flow rate of the base material or the rate of forming the component (34).

34. A method as claimed in any one of claims 30-33 comprising the step of programming the computer (42) to control the rate of cooling of the deposit (22) and/or substrate/component (26, 34).

35. A method as claimed in claim 34 wherein the rate of cooling of the deposit (22) and/or substrate/component (26, 34) is controlled by computer controlled adjustment to any one of the group comprising the flow of cooling fluid, the power of the laser(s) (14) or the rate of forming the component (34).

36. A method as claimed in claim 35 comprising the steps of monitoring the temperature of the deposit (22) and/or substrate/component (26, 34) via thermal detection equipment (44), inputting the temperature into the computer (42) and in response to a predetermined set of rules outputting a response to control the adjustment to ensure a preferential thermal gradient exists for single crystal growth into the deposit (22).

37. A method of repairing a component (34) as claimed in any one of claims 1-36.

38. A component (34) as formed or partly formed by the method any one of claims 1-38.

39. Apparatus for forming at least a part of a single crystal component (18) comprising a base material comprising;
apparatus (16) capable of directing a flow of base material (24) at a first location (22) on a substrate (26),
a laser (14) capable of directing a laser beam (20) towards the first location (22) to fuse the flow of base material (24) with the substrate thereby forming a deposit (22) on the substrate (26),
**characterised in that**, the apparatus includes means for controlling the rate of cooling (28) of the deposit (22) and/or substrate (26, 18) so that the single crystal extends into the deposit (22).

40. Apparatus according to claim 39, wherein the means for controlling the rate of cooling (28, 30) comprises a jet of fluid.

41. Apparatus according to claim 40 wherein the cooling fluid comprises a flow of inert gas.

42. Apparatus according to any one of claims 39-41 comprising a programmable computer (42) capable of controlling any one of the location of the deposit (22), the power of the laser (14) or the rate of cooling (28) of the deposit (22) and/or substrate/component (26, 34).
